# EUROPÄISCHE PATENTSCHRIFT

(11) **EP 2 949 045 B1**
(45) Veröffentlichungstag und Bekanntmachung des Hinweises auf die Patenterteilung: **24.08.2016**
(21) Anmeldenummer: 14701215.7
(22) Anmeldetag: 24.01.2014
(51) Int. Cl.: H03M 3/00, H02M 5/00

(54) **VERFAHREN UND VORRICHTUNG ZUM ERZEUGEN EINES DIGITALEN SIGNALS**
METHOD AND DEVICE FOR PRODUCING A DIGITAL SIGNAL
PROCÉDÉ ET DISPOSITIF DESTINÉS À GÉNÉRER UN SIGNAL NUMÉRIQUE

(30) Priorität: 26.01.2013 DE 102013201253
(43) Veröffentlichungstag der Anmeldung: 02.12.2015
(73) Patentinhaber: Lenze Automation GmbH, 31855 Aerzen (DE)
(72) Erfinder: DÜSTERBERG, Dirk, 31860 Emmerthal (DE); STICHWEH, Heiko, 31832 Springe (DE)
(74) Vertreter: Patentanwälte Ruff, Wilhelm, Beier, Dauster & Partner mbB
(86) Internationale Anmeldenummer: PCT/EP2014/051414
(87) Internationale Veröffentlichungsnummer: WO 2014/114755

(56) Entgegenhaltungen:
- EP-A1- 0 335 988
- WO-A2-02/091581
- GB-A- 2 440 559
- JP-A- 2006 140 962
- US-A- 5 646 621
- US-A1- 2006 103 555
- US-A1- 2006 170 579
- US-A1- 2010 085 230

## Beschreibung

Die Erfindung betrifft ein Verfahren und eine Vorrichtung zum Erzeugen eines digitalen Signals aus einem mittels eines Frequenzumrichters auf Basis einer Pulsweitenmodulation mit veränderlicher Periodendauer erzeugten analogen Signal, wobei Werte des digitalen Signals einem Mittelwert des analogen Signals über eine zugehörige Periodendauer der Pulsweitenmodulation entsprechen.

Herkömmliche Frequenzumrichter geben typisch eine so genannte Phasenspannung aus, die auf Basis einer Pulsweitenmodulation erzeugt wird. Eine an einem mehrphasigen Elektromotor an einer Wicklung mittels des Frequenzumrichters erzeugte wirksame Spannung ist die Differenz zweier derartiger Phasenspannungen. Im Übrigen sei auch auf die einschlägige Fachliteratur verwiesen.

Bei der geregelten Ansteuerung von Elektromotoren kann es notwendig sein, den Gleichspannungsanteil der pulsweitenmodulierten Spannung bzw. der wirksamen Motorspannung zu bestimmen.

Die GB 2 440 559 A beschreibt ein Verfahren, bei dem eine von einem Frequenzumrichter erzeugte pulsweitenmodulierte Spannung unter Verwendung eines Sigma-Delta-Modulators digitalisiert wird. Zur Ermittlung eines jeweiligen digitalen Spannungsmesswerts wird fortlaufend ein Integral über genau eine zugehörige Periodendauer der Pulsweitenmodulation gebildet. Diese Integralbildung entspricht einem Hogenauer-Filter erster Ordnung.

Frequenzumrichter werden häufig im Verbund betrieben und hierbei mittels einer übergeordneten Steuerung synchronisiert. Im Zuge der Synchronisierung kann sich die Notwendigkeit ergeben, die der Pulsweitenmodulation zugrunde liegende Periodendauer zu verändern.

Bei dem in der GB 2 440 559 A beschriebenen Verfahren könnte eine Änderung der Periodendauer dadurch abgebildet werden, dass entsprechend mehr oder weniger Modulatortakte bei der Integration berücksichtigt werden.

Wenn aufgrund der Anforderungen an die Signalqualität digitale Filter höherer Ordnung notwendig werden, kann ein von einem Sigma-Delta-Modulator ausgegebener Bitstrom beispielsweise mittels eines Hogenauer-Filters höherer Ordnung, beispielsweise zweiter oder dritter Ordnung, gefiltert werden.

Die Übertragungsfunktion derartiger Hogenauer-Filter wird durch einen Takt des vom Sigma-Delta-Modulator ausgegebenen Bitstroms (Modulatortakt), eine Filterordnung und das so genannte Oversampling-Ratio bestimmt. Das Oversampling-Ratio beschreibt das bei der Abtastratenkonvertierung entstehende Verhältnis zwischen Eingangsabtastrate und Ausgangsabtastrate (Samplerate), d.h. das Verhältnis zwischen dem Modulatortakt und dem Takt der vom Filter ausgegebenen, gefilterten Werte bzw. Samples. Die Samplerate ergibt sich folglich aus dem Modulatortakt geteilt durch das Oversampling-Ratio. Im Übrigen sei diesbezüglich auch auf die einschlägige Fachliteratur verwiesen.

Um mit einem Hogenauer-Filter eine Spannungsmessung in einem pulsweitenmodulierenden System vornehmen zu können, muss die sich ergebene Samplerate des Hogenauer-Filters möglichst exakt ein ganzzahliges Vielfaches der Grundfrequenz der Pulsweitenmodulation sein, um die Schaltfrequenz effektiv unterdrücken zu können. Über diese innerhalb einer jeweiligen Periode der Pulsweitenmodulation liegenden Samples kann dann ein Integral bzw. Mittelwert gebildet werden, um die Kerbfrequenz auf die Schaltfrequenz zu legen.

Um das oben genannte Verfahren an eine veränderliche Periodendauer der Pulsweitenmodulation anzupassen, kann beispielsweise der Modulatortakt dynamisch an die Periodendauer angepasst werden. Ein Jitter des Modulatortakts oder ein Auslassen von Takten führt jedoch zu einer deutlichen Reduzierung der maximal möglichen effektiven Bits (ENOB). Alternativ oder zusätzlich kann eine dynamische Anpassung des Oversampling-Ratio an die Periodendauer der Pulsweitenmodulation erfolgen, die jedoch beim Hogenauer-Filter beim Anpassen zu Fehlberechnungen führt und zudem Einfluss auf das Frequenzverhalten und die Verstärkung des Hogenauer-Filters hat.

Der Erfindung liegt die Aufgabe zugrunde, ein Verfahren und eine Vorrichtung zum Erzeugen eines digitalen Signals aus einem mittels eines Frequenzumrichters auf Basis einer Pulsweitenmodulation mit veränderlicher Periodendauer erzeugten analogen Signal zur Verfügung zu stellen, die an eine veränderliche Periodendauer einfach anpassbar sind und mittels der Filter mit einer Ordnung größer Eins realisierbar sind.

Die Erfindung löst diese Aufgabe durch ein Verfahren nach Anspruch 1 und eine Vorrichtung nach Anspruch 9.

Das Verfahren dient zum Erzeugen eines digitalen Signals aus einem analogen Signal, das mittels eines Frequenzumrichters auf Basis einer Pulsweitenmodulation mit veränderlicher Periodendauer erzeugt wird. Werte des digitalen Signals entsprechen einem Mittelwert des analogen Signals über eine zugehörige Periodendauer der Pulsweitenmodulation.

Das digitale Signal bzw. dessen Werte wird/werden fortlaufend, für jede Periode des pulsweitenmodulierten analogen Signals erzeugt. Die Werte des digitalen Signals weisen einen abgegrenzten und gestuften Wertvorrat auf. Das digitale Signal kann weiter in seiner zeitlichen Abfolge nur zu bestimmten periodischen Zeitpunkten, beispielsweise am Ende einer jeweiligen Periode des pulsweitenmodulierten analogen Signals, definiert sein bzw. eine Veränderung in seinen Werten aufweisen. Das digitale Signal wird aus dem analogen Signal, welches den zeitlich kontinuierlichen Verlauf einer physikalischen Größe, beispielsweise Strom oder Spannung, beschreibt, durch Abtastung, welche zu definierten Zeitpunkten erfolgt, und Quantisierung gebildet. Durch eine entsprechende Kodierung kann das digitale Signal bzw. dessen Werte in eine binäre Darstellung übergeführt werden, beispielsweise mit 8, 16, 24 oder 32 Bit Digitalwortbreite.

Bei dem Verfahren wird ein Bitstrom (binärer Wertebereich Null und Eins) in Abhängigkeit von dem analogen Signal mittels eines herkömmlichen Sigma-Delta-Modulators erzeugt, wobei der Bitstrom mit einem konstanten Modulatortakt, beispielsweise in einem Modulatortaktbereich zwischen 5 MHz und 50 MHz, erzeugt wird.

Aus dem derart erzeugten Bitstrom werden mehrere zeitlich aufeinanderfolgende digitale Abtastwerte oder Samples während einer jeweiligen Periodendauer bzw. einer jeweiligen Periode der Pulsweitenmodulation erzeugt. Die digitalen Abtastwerte oder Samples können binär mit einer Wortbreite von beispielsweise 2, 4, 8, 16 oder 32 Bit kodiert sein.

Zeitliche Abstände zwischen jeweils aufeinanderfolgenden digitalen Abtastwerten betragen ganzzahlige Vielfache des Modulatortakts.

Das Erzeugen der zeitlich aufeinanderfolgenden digitalen Abtastwerte beinhaltet folgende Schritte:
Der Bitstrom wird mittels einer Anzahl (mindestens zwei) von voneinander unabhängigen digitalen, insbesondere abtastratenreduzierenden, Filtern zur Erzeugung der digitalen Abtastwerte gefiltert, wobei die digitalen Filter zeitversetzt, in dem gewünschten zeitlichen Abstand der aufeinanderfolgenden digitalen Abtastwerte gestartet werden. Nach dem Starten eines jeweiligen Filters kann dieser im Modulatortakt mit der Bitfolge beaufschlagt werden und seiner Filterfunktion entsprechend die Bitwerte der Bitfolge verarbeiten, eine Bitratenreduktion durchführen, nach einer Verarbeitungsdauer seinen zugehörigen digitalen Abtastwert ausgeben, usw.

Die Periodendauer ist in Vielfachen des Modulatortakts darstellbar. Wenn die Periodendauer k Modulatortakte beträgt und eine Anzahl von Abtastwerten oder Samples, die während einer jeweiligen Periodendauer bzw. einer jeweiligen Periode der Pulsweitenmodulation erzeugt und über die jeweiligen Periodendauer bzw. jeweilige Periode verteilt werden, r beträgt, werden die zeitlichen Abstände zwischen aufeinanderfolgenden digitalen Abtastwerten jeweils auf k/r Modulatortakte eingestellt, vorausgesetzt dass k durch r ohne Rest teilbar ist. Für diesen Fall sind die digitalen Abtastwerte vollständig äquidistant über die Periodendauer bzw. Periode verteilt.

Falls k durch r nicht ohne Rest teilbar ist, werden die zeitlichen Abstände zwischen aufeinanderfolgenden Abtastwerten derart eingestellt, dass sich eine möglichst zeitlich äquidistante Verteilung der Abtastwerte über die Periodendauer bzw. Periode ergibt, wobei eine Summe der zeitlichen Abstände zwischen den aufeinanderfolgenden Abtastwerten gleich der Periodendauer ist.

Wenn als ein Zahlenbeispiel die Periodendauer in Modulatortakteinheiten k = 31 und die Anzahl von Abtastwerten oder Samples r = 3 betragen, können die zeitlichen Abstände in Modulatortakteinheiten (11, 10, 10), (10, 11, 10) oder (10, 10, 11) betragen.

Wenn als weiteres Zahlenbeispiel die Periodendauer in Modulatortakteinheiten k = 32 und r = 3 betragen, können die zeitlichen Abstände (11, 11, 10), (10, 11, 11) oder (11, 10, 11) betragen.

Wenn schließlich als weiteres Zahlenbeispiel die Periodendauer in Modulatortakteinheiten k = 33 und r = 3 betragen, werden als äquidistante Verteilung die zeitlichen Abstände (11, 11, 11) gewählt.

Die digitalen Filter können während der Periodendauer bzw. Periode zumindest temporär zeitlich überlappend betrieben werden bzw. arbeiten.

Ein jeweiliges digitales Filter gibt einen zugehörigen digitalen Abtastwert bzw. ein zugehöriges Sample aus, wobei die digitalen Abtastwerte bzw. Samples von den unterschiedlichen digitalen Filtern ebenfalls zueinander zeitlich beabstandet ausgegeben werden.

Durch Bilden eines Mittelwerts über die während der Periodendauer bzw. Periode erzeugten digitalen Abtastwerte wird ein zu der jeweiligen Periodendauer bzw. Periode gehörender Wert des digitalen Signals berechnet, der den Mittelwert des analogen Signals über die Periodendauer bzw. Periode repräsentiert.

Die zeitlichen Abstände zwischen den digitalen Abtastwerten können in Abhängigkeit von der veränderlichen Periodendauer PD eingestellt bzw. berechnet werden. Die Anzahl der digitalen Abtastwerte pro Periodendauer bzw. Periode kann unabhängig von der Periodendauer konstant festgelegt werden. Es ist lediglich zu bewirken, dass sich eine möglichst äquidistante Verteilung der digitalen Abtastwerte innerhalb der Periodendauer bzw. der Periode ergibt. Mit anderen Worten werden die zeitlichen Abstände zwischen den digitalen Abtastwerten derart in Abhängigkeit von der veränderlichen Periodendauer PD eingestellt bzw. berechnet, dass sich eine möglichst zeitlich äquidistante Verteilung der digitalen Abtastwerte über die Periode bzw. Periodendauer ergibt.

Ein jeweiliges digitales Filter kann eine sinc³-Filterfunktion aufweisen bzw. realisieren.

Ein jeweiliges digitales Filter kann dazu ausgebildet sein, alle n Modulatortakte einen zugehörigen digitalen Abtastwert auszugeben.

Die zeitlichen Abstände zwischen den zeitlich aufeinanderfolgenden digitalen Abtastwerten in Modulatortakteinheiten können jeweils kleiner als n sein, um Gewichtungslücken zu vermeiden.

Die Anzahl der digitalen Filter kann gleich der Anzahl von digitalen Abtastwerten pro Periodendauer der Pulsweitenmodulation gewählt werden, d.h. jedes digitale Filter gibt genau einen zugehörigen digitalen Abtastwert aus.

Alternativ kann die Anzahl der digitalen Filter kleiner als die Anzahl von digitalen Abtastwerten pro Periodendauer der Pulsweitenmodulation gewählt werden, d.h. ein digitales Filter gibt im Laufe der Periodendauer bzw. Periode nacheinander mehr als nur einen einzelnen zugehörigen digitalen Abtastwert aus. Für diesen Fall wird das digitale Filter unmittelbar oder nach einer Wartezeit erneut gestartet, nachdem es einen digitalen Abtastwert ausgegeben hat.

Es kann 64 ≤ n ≤ 128 gelten.

Die digitalen Filter können jeweils identische Gewichtsfunktionen (Impulsantwort) aufweisen, wobei die digitalen Filter derart zeitversetzt zueinander gestartet werden, dass sich Gewichtsfunktionen digitaler Filter, die zeitlich benachbarte digitale Abtastwerte erzeugen, zumindest teilweise überlappen.

Die Periodendauer der Pulsweitenmodulation kann in einem Bereich zwischen 62,5 µs und 1 ms.

Die Vorrichtung zum Erzeugen eines digitalen Signals aus einem mittels eines Frequenzumrichters auf Basis einer Pulsweitenmodulation mit veränderlicher Periodendauer erzeugten analogen Signal ist zur Durchführung des oben genannten Verfahrens ausgebildet. Die Vorrichtung weist auf: einen Sigma-Delta-Modulator zum Erzeugen des Bitstroms, eine Anzahl (mindestens zwei) von digitalen Filtern zum Filtern des Bitstroms und Erzeugen der digitalen Abtastwerte und einen Mittelwertbilder zum Bilden des Mittelwerts über die während der Periodendauer erzeugten digitalen Abtastwerte.

Die Erfindung wird nachfolgend unter Bezugnahme auf die Zeichnungen beschrieben, die Ausführungsformen der Erfindung darstellen. Hierbei zeigt schematisch:
Fig. 1 ein mittels eines Frequenzumrichters auf Basis einer Pulsweitenmodulation mit veränderlicher Periodendauer erzeugtes analoges Signal mit zugehörigen Gewichtsfunktionen digitaler Filter,
Fig. 2 eine Vorrichtung zum Erzeugen eines digitalen Signals aus dem in Fig. 1 gezeigten analogen Signal gemäß einer ersten Ausführungsform,
Fig. 3 eine Vorrichtung zum Erzeugen eines digitalen Signals aus dem in Fig. 1 gezeigten analogen Signal gemäß einer weiteren Ausführungsform und
Fig. 4 schematisch die Verteilung von digitalen Abtastwerten über eine zugehörige Periodendauer.

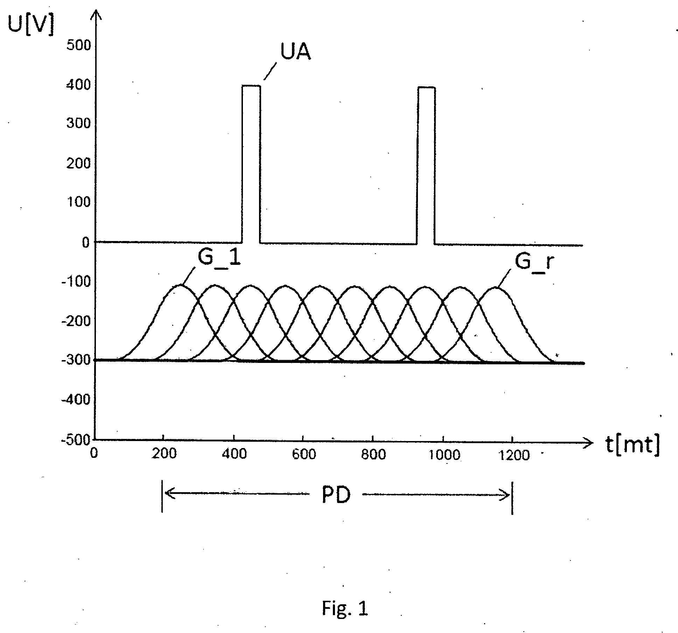

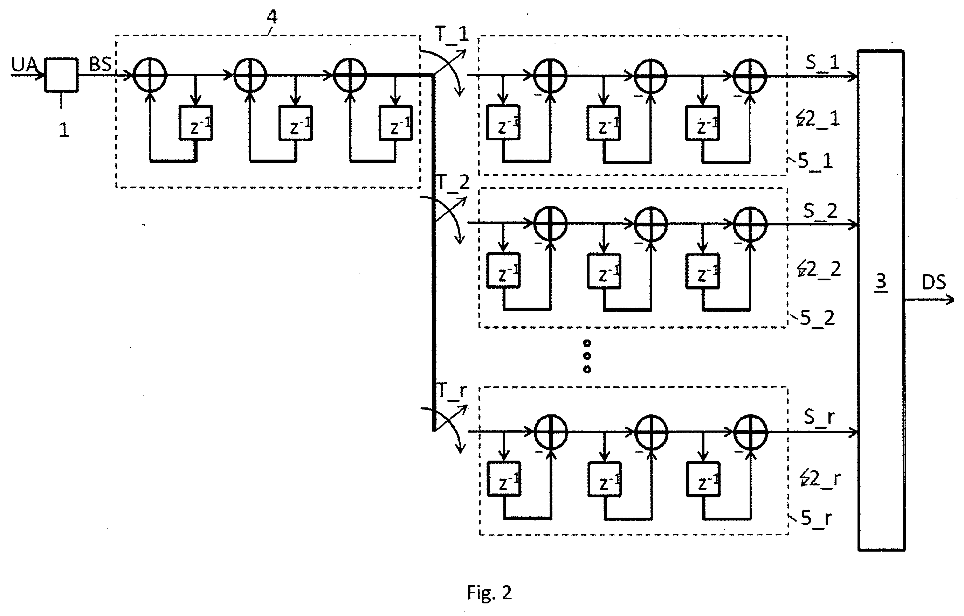

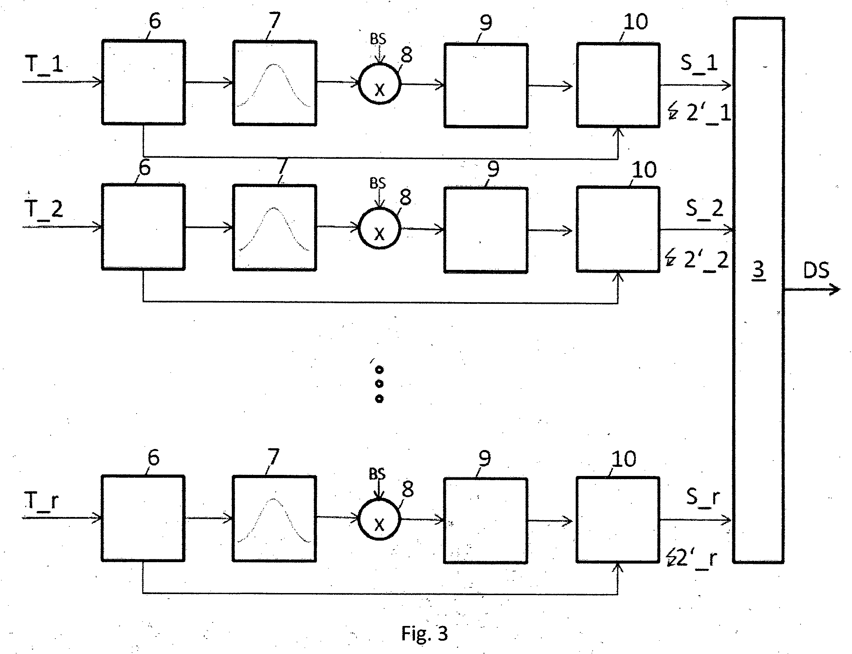

Fig. 1 zeigt ein mittels eines herkömmlichen, nicht dargestellten Frequenzumrichters auf Basis einer Pulsweitenmodulation mit veränderlicher Periodendauer PD erzeugtes analoges Signal in Form einer Spannung UA mit zugeordneten Gewichtsfunktionen G_1 bis G_r digitaler Filter (siehe Fig. 2 digitale Filter 2_1 bis 2_r sowie Fig. 3 digitale Filter 2'_1 bis 2'_r) über der Zeit in Modulatortakteinheiten mt.

Das analoge Signal bzw. die Spannung UA ist die resultierende Spannung an einer Motorwicklung eines nicht dargestellten Elektromotors im Kontext der Ansteuerung durch den herkömmlichen Frequenzumrichter.

In Fig. 1 ist exemplarisch eine Periode bzw. Periodendauer PD gezeigt. Es versteht sich, dass das Verfahren für vorausgehende Perioden bzw. Periodendauern und nachfolgende Perioden bzw. Periodendauern entsprechend durchgeführt wird.

Fig. 2 zeigt eine Vorrichtung zum Erzeugen eines digitalen Signals DS aus dem in Fig. 1 gezeigten analogen Signal UA gemäß einer ersten Ausführungsform, wobei Werte des digitalen Signals DS einen Mittelwert des analogen Signals UA über eine entsprechende Periode bzw. Periodendauer PD abbilden.

Die Vorrichtung weist einen herkömmlichen Sigma-Delta-Modulator 1 auf, der mit der Spannung UA beaufschlagt ist. Es versteht sich, dass ein geeigneter, nicht dargestellter Pegelwandler vorgesehen sein kann, der die Spannung UA auf einen für den Sigma-Delta-Modulator 1 geeigneten Spannungspegel wandelt.

Der Sigma-Delta-Modulator 1 erzeugt herkömmlich einen Bitstroms BS in Abhängigkeit von dem analogen Signal UA mit einem konstanten Modulatortakt von beispielsweise 20 MHz.

Der Bitstrom wird von einem modifizierten Hogenauer-Filter 3. Ordnung mit interleaved bzw. zeitlich überlappend arbeitenden Dezimierstufen verarbeitet.

Das modifizierte Hogenauer-Filter weist eine gemeinsame Integratorstufe 4 und r unterschiedliche Kammstufen 5_1 bis 5_r auf, wobei die Integratorstufe 4 und die Kammstufen 5_1 bis 5_r zusammen r digitale Hogenauer-Filter 2_1 bis 2_r3. Ordnung zum Filtern des Bitstroms BS und Erzeugen von zugehörigen digitalen Abtastwerte S_1 bis S_r bilden.

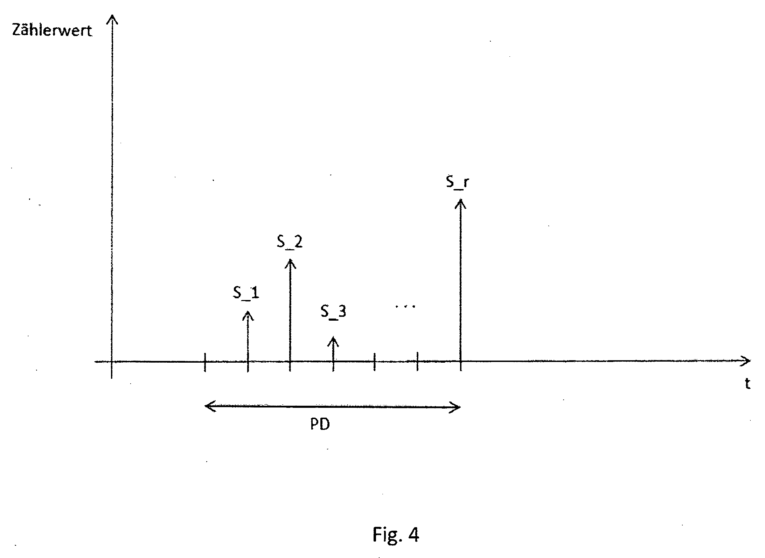

Die digitalen Abtastwerte S_1 bis S_r werden mittels der zugehörigen digitalen Filter 2_1 bis 2_r zeitlich aufeinanderfolgend erzeugt (siehe Fig. 4), wobei die zeitlichen Abstände zwischen den digitalen Abtastwerten S_1 bis S_r in ganzzahligen Vielfachen des Modulatortakts darstellbar sind.

Die digitalen Filter 2_1 bis 2_r werden zeitversetzt zueinander, in den entsprechenden zeitlichen Abständen gestartet, so dass diese entsprechend zeitversetzt ihre zugehörigen digitalen Abtastwert S_1 bis S_r ausgeben.

Startzeitpunkte T1 bis T_r der digitalen Filter 2_1 bis 2_r sind möglichst äquidistant über die Periode bzw. Periodendauer PD verteilt, so dass die zugehörigen Gewichtsfunktionen G_1 bis G_r der digitalen Filter 2_1 bis 2_r entsprechend möglichst äquidistant über die Periode bzw.

Periodendauer PD verteilt sind, siehe Fig. 1. Wie in Fig. 1 gezeigt, arbeiten zu bestimmten Zeitpunkten mehrere der digitalen Filter 2_1 bis 2_r gleichzeitig bzw. überlappend.

Die digitalen Filter weisen ein konstantes und untereinander identisches Oversampling-Ratio von beispielsweise 128 auf.

Bei einer Änderung der Periodendauer PD werden die zeitlichen Abstände bzw. Startzeitpunkte T1 bis T_r derart nachgeführt, dass eine möglichst äquidistante Verteilung der Gewichtungsfunktionen G_1 bis G_r innerhalb der Periodendauer bzw. Periode PD erhalten bleibt, d.h. die digitalen Abtastwerte S_1 bis S_r in möglichst gleichen zeitlichen Abständen erzeugt werden.

Ein Mittelwertbilder 3 dient zum Bilden eines Mittelwerts über die während der Periodendauer PD erzeugten digitalen Abtastwerte S_1 bis S_r, wobei der Mittelwert den Wert des digitalen Signals (DS) für die zugehörige Periodendauer PD bildet.

Fig. 3 zeigt eine Vorrichtung zum Erzeugen des digitalen Signals DS aus dem in Fig. 1 gezeigten analogen Signal UA gemäß einer weiteren Ausführungsform.

Bei der in Fig. 3 gezeigten Ausführungsform werden zur Erzeugung der digitalen Abtastwerte S_1 bis S_r digitale Filter 2'_1 bis 2'_r verwendet, wie sie in der nicht vorveröffentlichten deutschen Patentanmeldung DE 10 2011 080 586 beschrieben sind, deren Offenbarung hiermit zum Inhalt der vorliegenden Beschreibung gemacht wird, soweit sie die digitalen Filter 2'_1 bis 2'_r betrifft.

Die digitalen Filter 2'_1 bis 2'_r weisen jeweils einen Zähler 6, einen Speicher 7, einen Mischer 8, einen Integrator 9 und einen Zwischenspeicher 10 auf. Hinsichtlich der Funktion dieser Einheiten sei auf die DE 10 2011 080 586 verwiesen.

Die Ansteuerung der digitalen Filter 2_1 bis 2_r bzw. 2'_1 bis 2'_r und des Mittelwertbilders 3, die Berechnung der optimalen zeitlichen Abstände und weitere allgemeine Steueraufgaben werden von einer nicht gezeigten Steuereinheit durchgeführt. Sämtliche Einheiten können beispielsweise in ein FPGA integriert sein.

Fig. 4 zeigt exemplarisch, wie die digitalen Abtastwerte S_1 bis S_r mittels der zugehörigen digitalen Filter 2_1 bis 2_r 2'_1 bis 2'_r zeitlich aufeinanderfolgend erzeugt werden.

Erfindungsgemäß werden anstelle eines einzelnen digitalen Filters, welches einen einzelnen oder zeitlich aufeinanderfolgend mehrere digitale Abtastwerte pro Periode erzeugt, eine Mehrzahl von digitalen Filtern interleaved betrieben, wobei zur Anpassung an eine variable Periodendauer die Startzeitpunkte der Mehrzahl von digitalen Filtern derart nachgeführt werden, dass die von den digitalen Filtern erzeugten digitalen Abtastwerte möglichst zeitlich äquidistant über die Periode bzw. Periodendauer verteilt sind.

## Patentansprüche

1. Verfahren zum Erzeugen eines digitalen Signals (DS) aus einem mittels eines Frequenzumrichters auf Basis einer Pulsweitenmodulation mit veränderlicher Periodendauer (PD) erzeugten analogen Signal (UA), wobei Werte des digitalen Signals (DS) einem Mittelwert des analogen Signals (UA) über eine zugehörige Periodendauer (PD) der Pulsweitenmodulation entsprechen, mit den Schritten:
- Erzeugen eines Bitstroms (BS) in Abhängigkeit von dem analogen Signal (UA) mittels eines Sigma-Delta-Modulators (1), wobei der Bitstrom mit einem konstanten Modulatortakt erzeugt wird,
- Erzeugen von zeitlich aufeinanderfolgenden digitalen Abtastwerten (S_1 bis S_r) während einer zugehörigen Periodendauer (PD) durch Filtern des Bitstroms (BS) mittels einer Anzahl von digitalen Filtern (2_1 bis 2_r; 2'_1 bis 2'_r), wobei
- zeitliche Abstände zwischen den zeitlich aufeinanderfolgenden digitalen Abtastwerten Vielfache des Modulatortakts sind,
- die digitalen Filter (2_1 bis 2_r; 2'_1 bis 2'_r) zeitversetzt zueinander, in den zeitlichen Abständen der Vielfachen des Modulatortakts gestartet werden und
- ein jeweiliges digitales Filter (2_1 bis 2_r; 2'_1 bis 2'_r) einen zugehörigen digitalen Abtastwert (S_1 bis S_r) ausgibt, und
- Bilden eines Mittelwerts über die während der zugehörigen Periodendauer (PD) erzeugten digitalen Abtastwerte (S_1 bis S_r), wobei der Mittelwert den Wert des digitalen Signals (DS) für die zugehörige Periodendauer bildet.

2. Verfahren nach Anspruch 1, **dadurch gekennzeichnet, dass** die zeitlichen Abstände zwischen den zeitlich aufeinanderfolgenden digitalen Abtastwerten in Abhängigkeit von der veränderlichen Periodendauer (PD) eingestellt werden.

3. Verfahren nach Anspruch 1 oder 2, **dadurch gekennzeichnet, dass** ein jeweiliges digitales Filter eine sinc³-Filterfunktion aufweist.

4. Verfahren nach einem der vorhergehenden Ansprüche, **dadurch gekennzeichnet, dass** ein jeweiliges digitales Filter (2_1 bis 2_r; 2'_1 bis 2'_r) dazu ausgebildet ist, alle n Modulatortakte einen zugehörigen digitalen Abtastwert (S_1 bis S_r) auszugeben.

5. Verfahren nach Anspruch 4, **dadurch gekennzeichnet, dass** die zeitlichen Abstände zwischen den zeitlich aufeinanderfolgenden digitalen Abtastwerten in Modulatortakteinheiten kleiner als n sind.

6. Verfahren nach Anspruch 4 oder 5, **dadurch gekennzeichnet, dass** 64 ≤ n ≤ 128.

7. Verfahren nach einem der vorhergehenden Ansprüche, **dadurch gekennzeichnet, dass** die digitalen Filter jeweils identische Gewichtsfunktionen aufweisen, wobei die digitalen Filter (2_1 bis 2_r; 2'_1 bis 2'_r) derart zeitversetzt zueinander gestartet werden, dass sich Gewichtsfunktionen digitaler Filter, die zeitlich benachbarte digitale Abtastwerte erzeugen, zumindest teilweise überlappen.

8. Verfahren nach einem der vorhergehenden Ansprüche, **dadurch gekennzeichnet, dass** die Periodendauer (PD) in einem Bereich zwischen 62,5 µs und 1 ms liegt.

9. Vorrichtung zum Erzeugen eines digitalen Signals (DS) aus einem mittels eines Frequenzumrichters auf Basis einer Pulsweitenmodulation mit veränderlicher Periodendauer (PD) erzeugten analogen Signal (UA), die zur Durchführung des Verfahrens nach einem der vorhergehenden Ansprüche ausgebildet ist, aufweisend:
- einen Sigma-Delta-Modulator (1) zum Erzeugen des Bitstroms (BS),
- eine Anzahl von digitalen Filtern (2_1 bis 2_r; 2'_1 bis 2'_r) zum Filtern des Bitstroms (BS) und Erzeugen der digitalen Abtastwerte (S_1 bis S_r) und
- einen Mittelwertbilder (3) zum Bilden des Mittelwerts über die während der Periodendauer (PD) erzeugten digitalen Abtastwerte (S_1 bis S_r).

## Claims

1. A method for generating a digital signal (DS) from an analog signal (UA), which analog signal is generated by means of a frequency converter on the basis of pulse width modulation having a variable period duration (PD), wherein values of the digital signal (DS) correspond to an average value of the analog signal (UA) over an associated period duration (PD) of the pulse width modulation, the method comprising the steps:
- generating a bit stream (BS) on the basis of the analog signal (UA) using a sigma-delta modulator (1), wherein the bit stream is generated having a constant modulator clock,
- generating temporally successive digital sample values (S_1 to S_r) during an associated period duration (PD) by filtering the bit stream (BS) using a number of digital filters (2_1 to 2_r; 2'_1 to 2'_r), wherein
- intervals of time between the temporally successive digital samples are multiples of the modulator clock,
- the digital filters (2_1 to 2_r; 2'_1 to 2'_r) are started with a time delay with respect to one another, wherein the time delay is equal to the intervals of time of the multiples of the modulator clock, and
- a respective digital filter (2_1 to 2_r; 2'_1 to 2'_r) outputs an associated digital sample value (S_1 to S_r), and
- forming an average value of the digital samples (S_1 to S_r) generated during the associated period duration (PD), wherein the average value forms the value of the digital signal (DS) for the associated period duration.

2. The method according to claim 1, **characterized in that** the intervals of time between the temporally successive digital sample values are set on the basis of the variable period duration (PD).

3. The method according to claim 1 or 2, **characterized in that** a respective digital filter has a sinc³ filter function.

4. The method according to any of the preceding claims, **characterized in that** a respective digital filter (2_1 to 2_r; 2'_1 to 2'_r) is designed to output an associated digital sample value (S_1 to S_r) every n modulator clocks.

5. The method according to claim 4, **characterized in that** the intervals of time between the temporally successive digital sample values in modulator clock units are smaller than n.

6. The method according to claim 4 or 5, **characterized in that** 64 ≤ n ≤ 128.

7. The method according to any of the preceding claims, **characterized in that** the digital filters each have identical weighting functions, wherein the digital filters (2_1 to 2_r; 2'_1 to 2'_r) are started with a time delay with respect to one another in such a manner that weighting functions of digital filters which produce temporally adjacent digital sample values at least partially overlap.

8. The method according to any of the preceding claims, **characterized in that** the period duration (PD) is in a range between 62.5 µs and 1 ms.

9. A device for generating a digital signal (DS) from an analog signal (UA) generated using a frequency converter on the basis of pulse width modulation having a variable period duration (PD), wherein the device is designed to carry out the method according to any of the preceding claims, the device comprising:
- a sigma-delta modulator (1) for generating the bit stream (BS),
- a number of digital filters (2_1 to 2_r; 2'_1 to 2'_r) for filtering the bit stream (BS) and generating the digital sample values (S_1 to S_r), and
- an averager (3) for forming the average value of the digital sample values (S_1 to S_r) generated during the period duration (PD).

## Revendications

1. Procédé de génération d'un signal numérique (DS) à partir d'un signal analogique (UA) généré au moyen d'un convertisseur de fréquence sur la base d'une modulation d'impulsions en largeur à période (PD) variable, les valeurs du signal numérique (DS) correspondant à une valeur moyenne du signal analogique (UA) sur une période (PD) associée de la modulation d'impulsions en largeur, comprenant les étapes suivantes :
- génération d'un flux binaire (BS) en fonction du signal analogique (UA) au moyen d'un modulateur sigma-delta (1), le flux binaire étant généré avec un cycle de modulateur constant,
- génération de valeurs d'échantillonnage numériques (S_1 à S_r) chronologiquement consécutives pendant une période (PD) associée par filtrage du flux binaire (BS) au moyen d'un certain nombre de filtres numériques (2_1 à 2_r ; 2'_1 à 2'_r),
- les intervalles de temps entre les valeurs d'échantillonnage numériques chronologiquement consécutives étant des multiples du cycle de modulateur,
- les filtres numériques (2_1 à 2_r ; 2'_1 à 2'_r) étant démarrés dans les intervalles de temps des multiples du cycle de modulateur avec un décalage dans le temps les uns par rapport aux autres,
- un filtre numérique (2_1 à 2_r ; 2'_1 à 2'_r) respectif délivrant une valeur d'échantillonnage numérique (S_1 à S_r) associée, et
- formation d'une valeur moyenne sur les valeurs d'échantillonnage numériques (S_1 à S_r) générées pendant la période (PD) associée, la valeur moyenne formant la valeur du signal numérique (DS) pour la période associée.

2. Procédé selon la revendication 1, **caractérisé en ce que** les intervalles de temps entre les valeurs d'échantillonnage numériques chronologiquement consécutives sont réglés en fonction de la période (PD) variable.

3. Procédé selon la revendication 1 ou 2, **caractérisé en ce qu'**un filtre numérique respectif présente une fonction de filtrage sinc³.

4. Procédé selon l'une des revendications précédentes, **caractérisé en ce qu'**un filtre numérique (2_1 à 2_r ; 2'_1 à 2'_r) respectif est configuré pour délivrer une valeur d'échantillonnage numérique (S_1 à S_r) associée tous les n cycles de modulateur.

5. Procédé selon la revendication 4, **caractérisé en ce que** les intervalles de temps entre les valeurs d'échantillonnage numériques chronologiquement consécutives dans des unités de cycles de modulateur sont inférieurs à n.

6. Procédé selon la revendication 4 ou 5, **caractérisé en ce que** 64 ≤ n ≤ 128.

7. Procédé selon l'une des revendications précédentes, **caractérisé en ce que** les filtres numériques présentent des fonctions de pondération respectivement identiques, les filtres numériques (2_1 à 2_r ; 2'_1 à 2'_r) étant démarrés avec un décalage dans le temps les uns par rapport aux autres de telle sorte que les fonctions de pondération des filtres numériques qui génèrent des valeurs d'échantillonnage numériques chronologiquement voisines se chevauchent au moins partiellement.

8. Procédé selon l'une des revendications précédentes, **caractérisé en ce que** la période (PD) est comprise dans une plage entre 62,5 µs et 1 ms.

9. Dispositif de génération d'un signal numérique (DS) à partir d'un signal analogique (UA) généré au moyen d'un convertisseur de fréquence sur la base d'une modulation d'impulsions en largeur à période (PD) variable, lequel est configuré pour mettre en oeuvre le procédé selon l'une des revendications précédentes, comprenant :
- un modulateur sigma-delta (1) destiné à générer le flux binaire (BS),
- un certain nombre de filtres numériques (2_1 à 2_r ; 2'_1 à 2'_r) destinés à filtrer le flux binaire (BS) et à générer les valeurs d'échantillonnage numériques (S_1 à S_r), et
- un calculateur de moyenne (3) destiné à former la valeur moyenne sur les valeurs d'échantillonnage numériques (S_1 à S_r) générées pendant la période (PD).
